# EUROPEAN PATENT SPECIFICATION

(11) **EP 0 955 550 B1**
(45) Date of publication and mention of the grant of the patent: **17.08.2005**
(21) Application number: 99303472.7
(22) Date of filing: 04.05.1999
(51) Int. Cl.: G01R 31/08, G01R 31/12

(54) **Method of detecting electrical discharges**
Verfahren zur Detektion von elektrische Entladungen
Méthode pour détecter des décharges électriques

(30) Priority: 08.05.1998 GB 9809713
(43) Date of publication of application: 10.11.1999
(73) Proprietor: Pirelli Cables (2000) Limited, London W1K 4QZ (GB)
(72) Inventor: Barclay, Andrew Leslie, Bexley, Kent DA5 1AP (GB)
(74) Representative: Abbie, Andrew Kenneth

(56) References cited:
- US-A- 3 820 018
- US-A- 5 475 312
- PATENT ABSTRACTS OF JAPAN vol. 098, no. 001, 30 January 1998 (1998-01-30) & JP 09 243701 A (NISSIN ELECTRIC CO LTD), 19 September 1997 (1997-09-19)

## Description

This invention relates to a method of detecting electrical discharges and locating their sources; it relates primarily to "partial" discharges in electric power transmission systems, where ionisation is occurring in air or other dielectric medium but does not provide a complete conductive (breakdown) path from phase to phase or from phase to earth.

The detection of partial discharges is a useful tool for judging the quality of a power transmission system and for identifying potential sources of trouble so that they can be dealt with before breakdown occurs. Partial discharges may be observed with the system in service, or at least at service voltage, or with greater sensitivity using an alternating test voltage above (typically up to three times) the service voltage.

Where partial discharges occur in the external atmosphere, it is possible to locate them by sensitive directional acoustic detectors, but this is inapplicable to internal discharges (as the acoustic coupling to the atmosphere is insufficient) and may be disabled by external noise levels. Otherwise, current practice is to detect radio-frequency pulses generated by the partial discharge by means of sensors and instruments connected to the system or by using portable detectors moved to determine a position of maximum signal amplitude. This may be impracticable if the partial discharge is in a termination high above ground level on an overhead line tower and/or close to energised bare conductors, and is liable to confusion from extraneous signal sources: for example, a stray length of wire within the electromagnetic field of a major power line may generate radio-frequency pulses that are not easy to discriminate from those due to partial discharges.

US 3 820 018 discloses a movable antenna array for detecting partial discharges from electric power lines. A plurality of converters have respective directional antennae. In use, the user selects the converter and antenna that are suitable for detecting pulses in a particular frequency range. The detected pulses pass through the converter to an amplifier/detector where signals having a strength above a predetermined threshold are detected and amplified before being fed to a loudspeaker. Initially, the amplifier/detector is set to it maximum gain and a maximum threshold is set so that so that only signals above that maximum value are amplified. The user then moves the antenna until a maximum signal is heard from the loudspeaker. The antenna should then point towards the "noise source" and the user then walks towards the source and reduces the threshold so as to screen out noise from directions other than that of the noise source (noise from other sources (reflections) should not be strong enough to exceed the threshold). The user keeps moving towards the noise source while adjusting the threshold so as to focus on the pulses from the noise source. It is said that a user can normally walk to a utility pole that is the source of a discharge employing the 225 MHz converter 24 and its associated 225 MHz Yagi antenna, but that where there are multiple noise sources from other poles, it may be desirable to screen out the noise by switching to the 450 MHz converter 26 and the corresponding 450 MHz Yagi antenna. The D1 only ever uses one antenna (and thus one signal) at a time to seek out the partial discharges. The other antennae are disconnected when any particular one is in use. The user walks towards the source of the discharge following the noise from the loudspeaker.

The invention provides a method of detecting electrical discharges and locating their sources, the method comprising detecting radio-frequency radiation by means of a movable antenna array that provides at least two output signals and a receiver for receiving said output signals and interpreting the received said at least two signals in relation to the position and orientation of the antenna array to determine the direction of the partial discharge and thus the location of its source.

The invention provides a technique in which close approach to the locus of the partial discharge is not requried.

Normally the antennae in an array should be similarly polarised, so far as applicable.

Conventional radio-direction-finding techniques and apparatus can be used in the invention. Two rather different techniques will be described by way of illustration; the first is very much preferred.

### Time Domain Method

This form of the invention requires an array of at least two "non-directional" antennae. Simple dipoles can be used, but we prefer to use either "discone" antennae, which have an inherent broad-band response, or "multitrap" dipoles with several frequency-discriminating filters along their lengths to generate multiple resonant frequencies and thus a broad-band response: this has (in either case) the benefit that incoming pulse shapes are preserved and can be analysed for better understanding of their significance, compared with simple dipoles with a strong resonance at a single frequency which tends to produce an output pulse shape characterising the antenna more than the signal.

Such an array, on receipt of a radiated signal pulse will generate pulse outputs from each antenna: if the source is in the plane that is equidistant from both antennae, the output pulses will be simultaneous; if on the longitudinal axis of the antennae, they will be spaced by a time corresponding to the transit time of radiation over the distance between the antennae (a maximum spacing); an intermediate spacing indicates an oblique direction - or at least a substantially conical imaginary surface (strictly a hyperboloid of revolution, but the difference is significant only at short distances) in which the source must lie, but in practical conditions it can normally be assumed that the source is roughly in the same horizontal plane as the antenna array and on one side rather than the other. The direction of the signal can thus be computed: however, in a preferred form of this method, the antenna array is preferably rotated until the spacing of the pulses is maximised, and the position of the axis of the array then indicates unambiguously the direction of the source (assuming the directly opposite direction can be confidently rejected).

For added confidence, the array preferably comprises more than two antennae. A linear array of three or four antennae (say) will give duplicate measurements and allow immediate rejection of locally-generated error pulses since they will not give consistent spacing for different antenna pairs. A suitably designed non-linear array may enable the source direction to be unambiguously determined without rotation of the array.

The pulses received by the antennae may be interpreted in various ways. In a simple form of the invention, the output of each respective antennae is fed to a corresponding channel of an oscilloscope, *via* attenuators, filters and/or preamplifiers if and as appropriate and the resulting displays interpreted by an operator. Preferably the oscilloscope is of the kind using digital storage, or some other form of time-interval storage, to enable display to be triggered on occurrence of a pulse (or a pre-set pattern of pulses) over a threshold level and to display the pulse or pattern that triggered it. Alternatively the interpretation may be effected by software arranged to output signals indicating the direction of the discharge source and/or the direction in which the antenna array should be moved to obtain a better indication. The software may also analyse the shape of the received pulse for better understanding of the nature of the discharge source.

### Directional Antenna Method

In this alternative method, at least one tuned, highly directional antenna array (such as a Yagi array comprising a dipole antenna with a reflector on one side and a number of directors on the other) is required, and the direction of the source is indicated, in the simplest case, by the direction in which the antenna has to be pointed to maximise the received pulses.

Preferably the antenna array comprises at least two directional sub-units, and preferably they are identical and aligned so that their directions of maximum sensitivity diverge at a small angle (for example an angle of 5-15º). The difference in the magnitudes of corresponding pulses received by the two units then gives an immediate indication of the direction in which the array should be turned to equalise their magnitude, and when they are equalised the radiation source lies midway between the axes of the two sub-units. Addition of at least a third sub-unit allows the measurement to be extended to three dimensions; preferably a fourth unit is added in a square arrangement, as this both provides duplicate signals for verification and improves the balance and mechanical stability of the array.

As with the time-domain technique, interpretation may be manual using an oscilloscope display (but concentrating on the relative amplitudes of the pulses instead of their spacing), or may be wholly or partly software-based.

The invention will be further described, by way of example, with reference to the accompanying drawings in which:
Figures 1 and 2 are sketches illustrating a time-domain method in accordance with the invention and
Figure 3 is a corresponding sketch for a directional-antenna method.

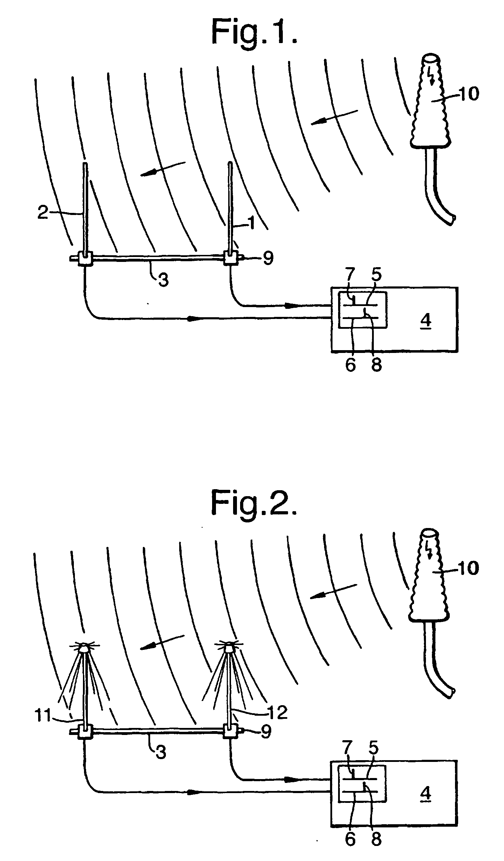

For simplicity, Figures 1 and 2 show only two antennae 1, 2 and 11, 12 respectively mounted on a support 3 to form a movable array; in a preferred form, there would be four antennae equally spaced in a normally-horizontal straight line. Each of antennae 1 and 2 is a vertically-polarised multitrap broadband (0.5 to 1300 MHz) dipole antenna while 11 and 12 are discone antennae of comparable bandwidth. In both cases, each antenna feeds output directly or indirectly to a corresponding channel of a multi-channel digital-storage oscilloscope 4 to be displayed as corresponding traces 5, 6. The trigger facility of the oscilloscope is used to display time segments beginning shortly before the appearance of a pulse on the first channel (corresponding to antenna 1 and trace 5) and the upper trace thus always shows a pulse 7 in substantially the same position. Lower trace 6 shows a similar shape but with corresponding peak 8 displaced to an extent varying with the position of the antenna array. The array is manipulated, if necessary, until the pulse 8 is later in time than pulse 7 and then adjusted to maximise the spacing (preferably the array is adjustable by a remotely controlled motor so that it can be adjusted from a convenient location for the oscilloscope) : the front 9 of the antenna array is now pointed towards the radiation source 10.

It will be appreciated that unequal delays in the transfer of signals from the individual antennae to the oscilloscope need to be avoided (for example by using cables of equal length) or if it is not convenient to avoid them need to be known and allowed for in the interpretation.

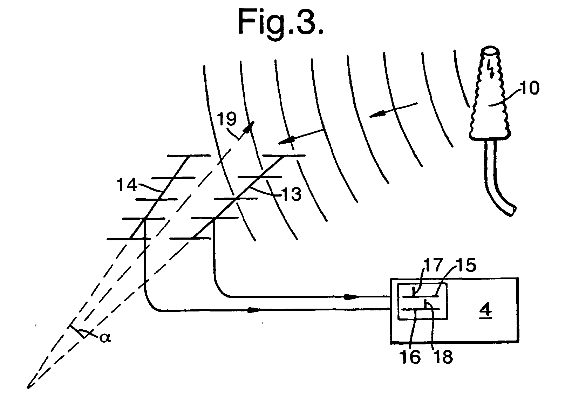

In the alternative method illustrated by Figure 3 the antenna array comprises at least two Yagi sub-units mounted on a common support (not shown, for clarity) with their axes of maximum sensitivity 13,14 diverging at an angle α. As in the first method, the outputs are fed to respective channels of the oscilloscope 4 to generate corresponding traces 15, 16 and the trigger facility is set to respond to and display pulses 17 on the first channel, together with the corresponding time-segments of the other channel. In this case the spacing of the pulses is ignored and the entire antenna array rotated to equalise the heights of the pulses 17, 18. The bisector 19 of the angle α now points towards the radiation source 10.

In an example based on the simple form of Figure 3, there are four Yagi sub-units arranged on a square so that each has a first neighbour horizontally spaced from it and a second neighbour vertically spaced from it, and the oscilloscope has four corresponding channels. Either all vertically- or all horizontally-polarised sub-units are used. Equalisation of all four pulses is achieved by adjusting the array in both horizontal and vertical planes. One suitable array comprises four 18-element 670 MHz Yagi array sub-units diverging at 10º in each plane.

It will be appreciated that, like any radio-frequency technique, the method of the invention will only enable partial discharge sources to be located to the extent that they are free to radiate. So (for example) in the rare case in which partial discharges occur within a cable, as distinct from in a joint, termination or other accessory, it will only be possible to identify the cable section in which the discharge occurs, as radiation will be blocked by the metal sheath of the cable.

## Claims

1. A method of detecting electrical discharges and locating their sources, the method comprising detecting radio-frequency radiation by means of a movable antenna array that provides at least two output signals and a receiver for receiving said output signals and interpreting the received said at least two signals in relation to the position and orientation of the antenna array to determine the direction of the partial discharge and thus the location of its source.

2. A method as claimed in claim 1, in which an array of at least two "non-directional" antennae generates output pulses and the spacing between the pulses from respective antennae is interpreted to indicate the direction of the discharge.

3. A method as claimed in claim 2, in which the antenna array is adjusted to maximise the spacing, so pointing the array at a discharge location.

4. A method as claimed in claim 2 or 3, comprising using as the antennae "multitrap" broad-band dipoles.

5. A method as claimed in claim 2 or 3, comprising using as the antenna "discone" broad-band antennae.

6. A method as claimed in any one of the preceding claims, comprising using a linear array of three or four antennae.

7. A method as claimed in any one of the preceding claims, comprising using a non-linear array of at least three antennae.

8. A method as claimed in claim 1, comprising using a movable antenna array comprising at least two directional sub-units which are identical and aligned so that their directions of maximum sensitivity diverge at a small angle.

9. A method as claimed in claim 8, comprising using at least a third sub-unit to extend the measurement to three dimensions.

10. A method as claimed in claim 9, comprising using four sub-units in a square arrangement.

## Patentansprüche

1. Verfahren zur Detektion von elektrischen Entladungen und zum Lokalisieren ihrer Quellen, wobei das Verfahren Folgendes umfasst: Erkennen von Hochfrequenzstrahlung mittels einer beweglichen Antennenanordnung, die wenigstens zwei Ausgangssignale aussendet, und eines Empfängers zum Empfangen der Ausgangssignale und Interpretieren der empfangenen wenigstens zwei Signale relativ zur Position und Ausrichtung der Antennenanordnung, um die Richtung der Teilentladung zu bestimmen und somit ihre Quelle zu lokalisieren.

2. Verfahren nach Anspruch 1, wobei eine Anordnung aus wenigstens zwei nicht-direktionalen Antennen Ausgabeimpulse erzeugt und die Abstände zwischen den Impulsen von jeweiligen Antennen als Anzeige der Richtung der Entladung interpretiert werden.

3. Verfahren nach Anspruch 2, wobei die Antennenanordnung so eingestellt ist, dass die Abstände maximiert werden, so dass die Anordnung zu dem Ort der Entladung weist.

4. Verfahren nach Anspruch 2 oder 3, das umfasst, Mehrfallen-Breitbanddipole als die Antennen zu verwenden.

5. Verfahren nach Anspruch 2 oder 3, das umfasst, Scheibenkonus-Breitbandantennen als die Antennen zu verwenden.

6. Verfahren nach einem der vorangehenden Ansprüche, das umfasst, eine lineare Anordnung aus drei oder vier Antennen zu verwenden.

7. Verfahren nach einem der vorangehenden Ansprüche, das umfasst, eine nicht-lineare Anordnung aus wenigstens drei Antennen zu verwenden.

8. Verfahren nach Anspruch 1, das umfasst, eine bewegliche Antennenanordnung zu verwenden, die wenigstens zwei direktionale Untereinheiten aufweist, die identisch sind und so ausgerichtet sind, dass die Richtungen ihrer größten Empfindlichkeit in einem kleinen Winkel divergieren.

9. Verfahren nach Anspruch 8, das umfasst, wenigstens eine dritte Untereinheit zu verwenden, um die Messung auf drei Richtungen zu erweitern.

10. Verfahren nach Anspruch 9, das umfasst, vier Untereinheiten in einer quadratischen Anordnung zu verwenden.

## Revendications

1. Procédé pour détecter des décharges électriques et localiser leurs sources, le procédé comprenant le fait de détecter un rayonnement de fréquences radio au moyen d'un groupement d'antennes mobile qui fournit au moins deux signaux de sortie et d'un récepteur pour recevoir lesdits signaux de sortie et interpréter lesdits au moins deux signaux reçus relativement à la position et à l'orientation du groupement d'antennes afin de déterminer la direction de la décharge partielle et ainsi l'emplacement de sa source.

2. Procédé selon la revendication 1, dans lequel un groupement d'au moins deux antennes "non directionnelles" produit des impulsions de sortie et l'espacement entre les impulsions provenant des antennes respectives est interprété pour indiquer la direction de la décharge.

3. Procédé selon la revendication 2, dans lequel le groupement d'antennes est réglé pour maximiser l'espacement, en pointant ainsi le groupement vers un emplacement de décharge.

4. Procédé selon la revendication 2 ou 3, comprenant le fait d'utiliser comme antennes des dipôles large bande à "pièges multiples".

5. Procédé selon la revendication 2 ou 3, comprenant le fait d'utiliser comme antennes des antennes large bande "discônes".

6. Procédé selon l'une quelconque des revendications précédentes, comprenant le fait d'utiliser un groupement linéaire de trois ou quatre antennes.

7. Procédé selon l'une quelconque des revendications précédentes, comprenant le fait d'utiliser un groupement non linéaire d'au moins trois antennes.

8. Procédé selon la revendication 1, comprenant le fait d'utiliser un groupement d'antennes mobile comprenant au moins deux sous-unités directionnelles qui sont identiques et alignées de telle manière que leurs directions de sensibilité maximale divergent d'un petit angle.

9. Procédé selon la revendication 8, comprenant le fait d'utiliser au moins une troisième sous-unité pour étendre la mesure à trois dimensions.

10. Procédé selon la revendication 9, comprenant le fait d'utiliser quatre sous-unités agencées en carré.
